# EUROPEAN PATENT SPECIFICATION

(11) **EP 3 719 168 B1**
(45) Date of publication and mention of the grant of the patent: **08.05.2024**
(21) Application number: 20168077.4
(22) Date of filing: 03.04.2020
(51) Int. Cl.: C23C 14/22, C23C 14/30, C23C 14/54

(54) **ELECTRON BEAM VAPOR DEPOSITION PROCESS**
ELEKTRONENSTRAHL-DAMPFABSCHEIDUNGSVERFAHREN
PROCÉDÉ DE DÉPÔT EN PHASE VAPEUR PAR FAISCEAU D'ÉLECTRONS

(30) Priority: 05.04.2019 US 201962829887 P; 30.03.2020 US 202016834244
(43) Date of publication of application: 07.10.2020
(73) Proprietor: RTX Corporation, Farmington, CT 06032 (US)
(72) Inventor: HAZEL, Brian T., Avon, CT 06001 (US); LITTON, David A., West Hartford, CT 06107 (US); WESSELS, Kaylan M., West Hartford, CT 06119 (US)
(74) Representative: Dehns

(56) References cited:
- EP-A1- 3 296 421
- EP-A2- 2 236 643
- US-A- 5 534 314

## Description

### BACKGROUND

The present disclosure is directed to the improved electron beam physical vapor deposition process, and more particularly the variation of pressure and temperature to increase the deposition rate.

Gas turbine engines are well developed mechanisms for converting chemical potential energy, in the form of fuel, to thermal energy and then to mechanical energy for use in propelling aircraft, generating electric power, pumping fluids etc. At this time, the major available avenue for improved efficiency of gas turbine engines appears to be the use of higher operating temperatures. However, the metallic materials used in gas turbine engines are currently very near the upper limits of their thermal stability. In the hottest portion of modem gas turbine engines, metallic materials are used at gas temperatures above their melting points. They survive because they are air cooled. But providing air cooling reduces engine efficiency.

Accordingly, there has been extensive development of thermal barrier coatings for use with cooled gas turbine aircraft hardware. By using a thermal barrier coating, the amount of cooling air required can be substantially reduced, thus providing a corresponding increase in efficiency.

Thermal barrier coatings have been deposited by several techniques including thermal spraying (plasma, flame and HVOF), sputtering and electron beam physical vapor deposition (EBPVD). Of these techniques, electron beam physical vapor deposition is currently a preferred technique for demanding applications because it produces a unique coating structure. Electron beam physical vapor deposited ceramic materials, when applied according to certain parameters, have a columnar grain microstructure consisting of small columns separated by gaps which extend into the coating. These gaps allow substantial substrate expansion without coating cracking and/or spalling. US5534314A and EP3296421A1 disclose systems of the prior art.

Despite the success with the current use of electron beam physical vapor deposited zirconia base coatings, there is a continuing desire for improved coatings which exhibit superior thermal insulation capabilities, especially those improved in insulation capabilities when normalized for coating density. Weight is always a critical factor when designing gas turbine engines, particularly rotating parts. Ceramic thermal barrier coatings are not load supporting materials, and consequently they add weight without increasing strength. There is a strong desire for a ceramic thermal barrier material which adds the minimum weight while providing the maximum thermal insulation capability. In addition, there are obviously the normal desires for long life, stability, economy and the like.

### SUMMARY

In one aspect, there is provided an electron beam vapor deposition process according to claim 1.

In optional embodiment, the process further comprises pressurizing the coating chamber from about 0.5 microbar to about 20 microbar (0.05 - 2.0 Pa) with a corresponding lower temperature limit of the work piece of from 1890-1920 degrees Fahrenheit (1032 - 1049°C).

In optional embodiment, the process further comprising shortening a mean free path of molecules within said vapor cloud thereby reducing the kinetic energy of said molecules.

In optional embodiment, the process further comprises pressurizing the coating chamber from about 0.5 microbar to about 20 microbar (0.05 - 2.0 Pa).

In optional embodiment, the process further comprises pressurizing the coating chamber from about 0.5 microbar to about 8 microbar (0.05 - 0.8 Pa).

In optional embodiment, the process further comprises heating the work piece surface to a lower temperature limit of from about 1838 degrees Fahrenheit to about 1850 degrees Fahrenheit (1003 - 1010°C) with a corresponding chamber pressure of 13.0 microbar (1.3 Pa).

Other details of the process are set forth in the following detailed description and the accompanying drawings wherein like reference numerals depict like elements.

### BRIEF DESCRIPTION OF THE DRAWINGS

FIG. 1 illustrates an exemplary electron beam vapor deposition apparatus
FIG. 2. is a graph representing an exemplary deposition rate versus pressure.

### DETAILED DESCRIPTION

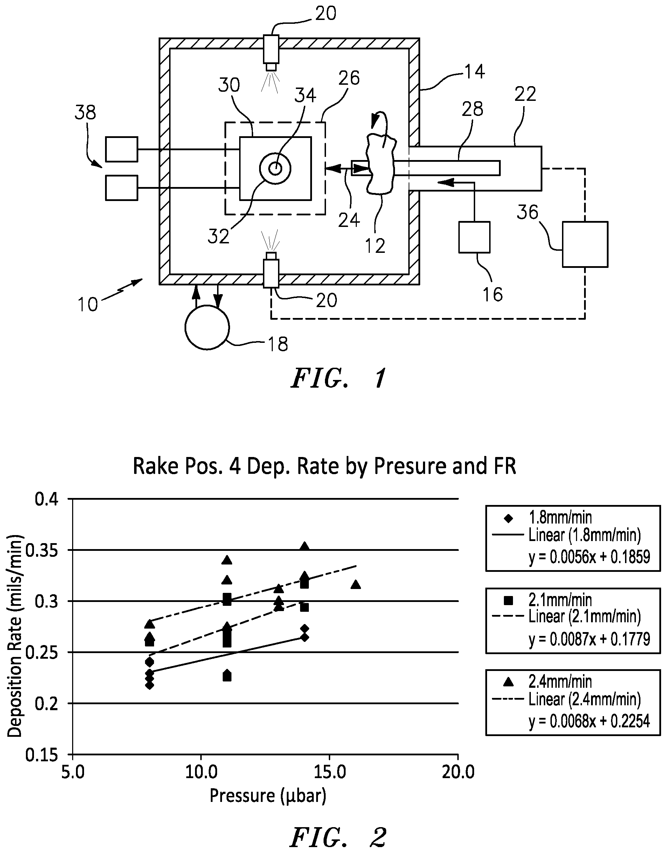

Figure 1 illustrates an example electron beam vapor deposition apparatus 10 (hereafter "the deposition apparatus 10") for coating a work piece 12 (or work pieces 12), such as airfoils, blades, vanes, combustion hardware, and blade out air seals or paired turbine vanes of a gas turbine engine.

Additionally, the type of coating deposited onto the work piece 12 may be any coating that is suitable for vapor deposition. For example, the coating may be a ceramic thermal barrier coating that includes gadolinia, zirconia, yttria, or combinations thereof.

The deposition apparatus 10 includes a coating chamber 14 for containing the work pieces 12 during a coating operation and establishing desirable coating conditions. For instance, the coating chamber 14 may be a vacuum chamber and may include various ports for evacuating the interior or for selectively introducing process gases. A gas source 16 may provide a desired flow of oxygen or other process gas into the coating chamber 14. Optionally, a pump 18 may circulate a coolant (e.g., water) through walls of the coating chamber 14 to control wall temperature. The gas source 16 can be used to increase the pressure in the coating chamber 14 to influence the coating deposition rate to improve throughput. The pressure in the coating chamber 14 can include an upper limit defined by an upper temperature limit. In an exemplary embodiment, for each 1 microbar (0.1 Pa) of pressure increase, a corresponding increase in coat temperature is required. For example, an increase in work piece temperature of 7.5-10.0 degrees Fahrenheit (4.2 - 5.6°C) increase in coat temperature can be made for each 1.0 microbar (0.1 Pa) increase in chamber pressure. When the coat temperature meets or exceeds the allowance for the substrate, then the maximum allowed pressure is also met. An upper limit can be defined by when a part temperature (increased due to pressure) equals the limit of the alloy of the work piece 12. In an exemplary embodiment, the coating chamber 14 pressure can be from 0.5 microbar to 40 microbar (0.05 - 4.0 Pa). In another exemplary embodiment, the coating chamber 14 pressure can be from 0.5 microbar to 20 microbar (0.05 - 2.0 Pa). In another exemplary embodiment, the pressure in the coating chamber 14 can be about 13 microbar (1.3 Pa). In an exemplary embodiment, the coating chamber 14 pressure can be from 0.5 microbar to 8 microbar (0.05 - 0.8 Pa).

At least one electron beam source 20, such as an electron gun, is mounted relative to the coating chamber 14 for melting and evaporating a source coating material 34, such as an ingot. In the disclosed example, two electron beam sources 20 are shown; however, the deposition apparatus 10 may alternatively include a single electron beam source 20 or more than two electron beam sources 20. Given this description, one of ordinary skill in the art will recognize an appropriate number of the electron beam sources 20 to meet their particular needs. In an exemplary embodiment, there can be multiple source coating materials 34.

A transport 22 is configured to hold and move the work piece 12 back and forth in direction 24, including rotation, tilt/pitch, and other degrees of motion to move the work piece 12 in and out of the coating chamber 14 and in and out of a coating zone 26 where the work piece 12 is to be coated. For instance, the coating zone 26 may be the spatial volume in the coating chamber 14 where the work piece 12 is coated. In this example, the transport 22 includes a shaft 28 that may be adapted to receive one or more fixtures that hold one or more of the work pieces 12. The shaft 28 may be translated in a known manner using a motor, actuator, or the like.

A coating device 30 is located near the coating zone 26, such as below the coating zone 26, and includes at least one crucible 32 for presenting at least one source coating material 34 that is to be deposited onto the work piece 12. For instance, the coating device 30 may include a single crucible that is used for the deposition apparatus 10. A desirable stand-off distance may be established between the coating device 30 and the coating zone 26 and/or work piece 12, depending on the geometry of the work piece 12, settings of the electron beam source(s) 20, and other factors.

Optionally, the deposition apparatus 10 may also include a thermal hood (not shown) arranged near the coating zone 26 to facilitate temperature control. As an example, one thermal hood is disclosed in application co-pending and commonly-owned Ser. No. 12/196,368 entitled "DEPOSITION APPARATUS HAVING THERMAL HOOD".

A controller 36 is in communication with the transport 22 and, optionally, the electron beam source 20 and possibly other components of the deposition apparatus 10 to control the operation thereof. The controller 36 may include software, hardware, or both for operating the deposition apparatus 10. The controller 36 may be configured to control movement of the work piece 12 in and out of the coating chamber 14 into the coating zone 26 and movement of the work piece 12 within the coating zone 26 during a coating operation. A deposition gas source(s) 38 is coupled to the crucible 32 and provides deposition gas.

The controller 36 can also control the feed rate of the ingot of deposition material being fed into the crucible 32.

With reference to Fig. 2, it has been discovered that the increase in coating chamber 14 pressure allows for increased deposition rates while maintaining a desired thermal barrier coating material 34 microstructure. The higher coating pressure, such as about 13 microbar (1.3 Pa), can result in more coating material being deposited for the same amount of ingot evaporated. The higher coating chamber pressure can result in increased coating material 34, such as ZrO₂, vapor pressure in the vapor cloud utilized during the coating process. The higher pressure in the coating chamber 34 can also translate to a shorter mean free path from the ingot surface to the work piece 12. Also lower energy deposit can result in lower density of the coating. The effect of where ambient pressure shapes vapor cloud to closer to normal trajectories from a pool surface can be found at Erikson, E. D. (1974). The thickness distribution of a metal-alloy from a high-rate electron-beam source can be found at J. Vac. Sci. Technol. 11(1), 366.

In an exemplary embodiment, the process can include an 8.0 microbar (0.8 Pa) chamber pressure with an allowed part temperature range of 1800 degrees Fahrenheit to 2000 degrees Fahrenheit (982 - 1093°C). In an exemplary embodiment, a chamber pressure to 13.0 microbar (1.3 Pa) can result in a lower temperature limit of from 1838-1850 degrees Fahrenheit (1003 - 1010°C) (with a 2000F (1093°C) max temp). In another exemplary embodiment, a chamber pressure to 20.0 microbar (2.0 Pa)can include a lower temp limit of the coat temperature of from 1890-1920 degrees Fahrenheit (1032 - 1049°C) (2000F (1093°C) max temp).

The disclosed process also includes varying the work piece 12 surface temperature relative to the coating chamber 14 pressure. Higher chamber pressure drives a shorter mean free path for the vaporized material. A shorter mean free path results in a larger number of vapor collisions prior to condensation on the part. Each vapor molecule collision with a molecule with less kinetic energy, such as a process gas molecule, reduces the kinetic energy of the vapor molecule. Additional energy can be added to the process by increasing the system temperature. System temperature as measured by part temperature should be increased as mean free path decreases and vapor collision frequency increases. This allows maintaining a constant adatom mobility which in term maintains an equivalent microstructure as chamber pressure is increased. A linear increase of 7.5-10.0 degree Fahrenheit (4.2 - 5.6°C) in part temperature is required for each 1.0 microbar (0.1 Pa) chamber pressure increase.

There has been provided a process. While the process has been described in the context of specific embodiments thereof, other unforeseen alternatives, modifications, and variations may become apparent to those skilled in the art having read the foregoing description. Accordingly, it is intended to embrace those alternatives, modifications, and variations which fall within the broad scope of the appended claims.

## Claims

1. An electron beam vapor deposition process for depositing coatings comprising:
providing a vapor deposition apparatus (10) having a coating chamber (14) for containing a work piece (12), the coating chamber (14) having a crucible (32);
placing a source coating material (34) in the crucible (32);
pressurizing said coating chamber (14) from about 0.5 microbar to about 40 microbar (0.05 - 4.0 Pa);
heating a work piece (12) surface to a temperature of from 1800 degrees Fahrenheit to 2000 degrees Fahrenheit (982 - 1093°C);
energizing said source coating material (34) with an electron beam that delivers a power density to the material (34) in the crucible (32) forming a vapor cloud from said source coating material (34); and
depositing said source coating material (34) onto a surface of a work piece.

2. The process according to claim 1, further comprising:
pressurizing said coating chamber (14) from about 0.5 microbar to about 20 microbar (0.05 - 2.0 Pa) with a corresponding lower temperature limit of the work piece (12) of from 1890-1920 degrees Fahrenheit (1032 - 1049°C).

3. The process according to claim 1, further comprising:
pressurizing said coating chamber (14) from about 0.5 microbar to about 20 microbar (0.05 - 2.0 Pa).

4. The process according to claim 1, further comprising:
pressurizing said coating chamber (14) from about 0.5 microbar to about 8 microbar (0.05 - 0.8 Pa).

5. The process according to claim 1, further comprising:
heating said work piece (12) surface to a lower temperature limit of from about 1838 degrees Fahrenheit to about 1850 degrees Fahrenheit (1003 - 1010°C) with a corresponding chamber (14) pressure of 13.0 microbar (1.3 Pa) .

6. The process according to any preceding claim, further comprising:
shortening a mean free path of molecules within said vapor cloud thereby reducing the kinetic energy of said molecules.

## Patentansprüche

1. Elektronenstrahl-Dampfabscheidungsverfahren zum Abscheiden von Beschichtungen, Folgendes umfassend:
Bereitstellen einer Dampfabscheidungsvorrichtung (10) mit einer Beschichtungskammer (14) zum Aufnehmen eines Werkstücks (12), wobei die Beschichtungskammer (14) einen Tiegel (32) aufweist;
Platzieren eines Ausgangsbeschichtungsmaterials (34) in dem Tiegel (32);
Unterdrucksetzen der Beschichtungskammer (14) von etwa 0,5 Mikrobar bis etwa 40 Mikrobar (0,05-4,0 Pa);
Erhitzen der Oberfläche eines Werkstücks (12) auf eine Temperatur von 1800 Grad Fahrenheit bis 2000 Grad Fahrenheit (982-1093 °C);
Erregen des Ausgangsbeschichtungsmaterials (34) mit einem Elektronenstrahl, der dem Material (34) in dem Tiegel (32) eine Leistungsdichte zuführt, wodurch eine Dampfwolke aus dem Ausgangsbeschichtungsmaterial (34) gebildet wird; und
Abscheiden des Ausgangsbeschichtungsmaterials (34) auf eine Oberfläche eines Werkstücks.

2. Verfahren nach Anspruch 1, ferner Folgendes umfassend:
Unterdrucksetzen der Beschichtungskammer (14) von etwa 0,5 Mikrobar bis etwa 20 Mikrobar (0,05-2,0 Pa) mit einer entsprechenden unteren Temperaturgrenze des Werkstücks (12) von 1890-1920 Grad Fahrenheit (1032-1049 °C).

3. Verfahren nach Anspruch 1, ferner Folgendes umfassend:
Unterdrucksetzen der Beschichtungskammer (14) von etwa 0,5 Mikrobar bis etwa 20 Mikrobar (0,05-2,0 Pa).

4. Verfahren nach Anspruch 1, ferner Folgendes umfassend:
Unterdrucksetzen der Beschichtungskammer (14) von etwa 0,5 Mikrobar bis etwa 8 Mikrobar (0,05-0,8 Pa).

5. Verfahren nach Anspruch 1, ferner Folgendes umfassend:
Erhitzen der Oberfläche des Werkstücks (12) auf eine untere Temperaturgrenze von etwa 1838 Grad Fahrenheit bis etwa 1850 Grad Fahrenheit (1003-1010 °C) mit einem entsprechenden Druck der Kammer (14) von 13,0 Mikrobar (1,3 Pa).

6. Verfahren nach einem der vorhergehenden Ansprüche, ferner Folgendes umfassend:
Verkürzen einer mittleren freien Weglänge von Molekülen innerhalb der Dampfwolke, wodurch die kinetische Energie der Moleküle verringert wird.

## Revendications

1. Procédé de dépôt en phase vapeur par faisceau d'électrons pour déposer des revêtements comprenant :
la fourniture d'un appareil de dépôt en phase vapeur (10) ayant une chambre de revêtement (14) pour contenir une pièce à travailler (12), la chambre de revêtement (14) ayant un creuset (32) ;
la mise en place d'un matériau de revêtement source (34) dans le creuset (32) ;
la mise de ladite chambre de revêtement (14) sous une pression d'environ 0,5 microbar à environ 40 microbars (0,05 à 4,0 Pa) ;
le chauffage d'une surface de la pièce à travailler (12) à une température de 1 800 degrés Fahrenheit à 2 000 degrés Fahrenheit (982 - 1 093 °C) ;
l'excitation dudit matériau de revêtement source (34) avec un faisceau d'électrons qui délivre une densité de puissance au matériau (34) dans le creuset (32) formant un nuage de vapeur à partir dudit matériau de revêtement source (34) ; et
le dépôt dudit matériau de revêtement source (34) sur une surface d'une pièce à travailler.

2. Procédé selon la revendication 1, comprenant en outre :
la mise de ladite chambre de revêtement (14) sous une pression d'environ 0,5 microbar à environ 20 microbars (0,05 à 2,0 Pa) avec une limite de température inférieure correspondante de la pièce à travailler (12) de 1 890 à 1 920degrés Fahrenheit (1 032 à 1 049 °C).

3. Procédé selon la revendication 1, comprenant en outre :
la mise de ladite chambre de revêtement (14) sous une pression d'environ 0,5 microbar à environ 20 microbars (0,05 à 2,0 Pa).

4. Procédé selon la revendication 1, comprenant en outre :
la mise de ladite chambre de revêtement (14) sous une pression d'environ 0,5 microbar à environ 8 microbars (0,05 à 0,8 Pa).

5. Procédé selon la revendication 1, comprenant en outre :
le chauffage de la surface de ladite pièce à travailler (12) à une limite de température inférieure d'environ 1 838 degrés Fahrenheit à environ 1 850 degrés Fahrenheit (1 003 - 1 010 °C) avec une pression de chambre (14) correspondante de 13,0 microbars (1,3 Pa).

6. Procédé selon une quelconque revendication précédente, comprenant en outre :
le raccourcissement du parcours libre moyen des molécules à l'intérieur dudit nuage de vapeur, réduisant ainsi l'énergie cinétique desdites molécules.
